# EUROPÄISCHE PATENTSCHRIFT

(11) **EP 1 142 185 B1**
(45) Veröffentlichungstag und Bekanntmachung des Hinweises auf die Patenterteilung: **10.03.2004**
(21) Anmeldenummer: 99966823.9
(22) Anmeldetag: 01.12.1999
(51) Int. Cl.: H04L 1/00

(54) **VERFAHREN UND ANORDNUNG ZUR KANALCODIERUNG BZW. DECODIERUNG VON IN RAHMEN STRUKTURIERTEN INFORMATIONEN**
METHOD AND ARRANGEMENT FOR CHANNEL CODING OR DECODING OF FRAME-STRUCTURED INFORMATION
PROCEDE ET SYSTEME POUR LE CODAGE DE CANAUX OU LE DECODAGE D'INFORMATIONS A STRUCTURE DE TRAME

(30) Priorität: 17.12.1998 DE 19858393
(43) Veröffentlichungstag der Anmeldung: 10.10.2001
(73) Patentinhaber: SIEMENS AKTIENGESELLSCHAFT, 80333 München (DE)
(72) Erfinder: HINDELANG, Thomas, D-81373 München (DE); HAGENAUER, Joachim, D-82229 Seefeld (DE); XU, Wen, D-82008 Unterhaching (DE)
(86) Internationale Anmeldenummer: PCT/DE1999/003838
(87) Internationale Veröffentlichungsnummer: WO 2000/036781

(56) Entgegenhaltungen:
- WO-A-96/27960
- US-A- 5 537 410

## Beschreibung

Die Erfindung betrifft ein Verfahren und eine Anordnung zur Kanalcodierung bzw. Decodierung von in Rahmen strukturierten Informationen, insbesondere im Rahmen einer adaptiven Multiratencodierung.

Quellensignale bzw. Quelleninformationen wie Sprach-, Ton-, Bild- und Videosignale beinhalten fast immer statistische Redundanz, also redundante Informationen. Durch eine Quellencodierung kann diese Redundanz stark verringert werden, so daß eine effiziente Übertragung bzw. Speicherung des Quellensignals ermöglicht wird. Diese Redundanzreduktion beseitigt vor der Übertragung redundante Signalinhalte, die auf der Vorkenntnis von z.B. statistischen Parametern des Signalverlaufs beruhen. Die Bitrate der quellencodierten Informationen (Quellbits oder Datenbits) wird auch Quellbitrate genannt. Nach der Übertragung werden bei der Quellendecodierung diese Anteile dem Signal wieder zugesetzt, so daß praktisch kein Qualitätsverlust nachweisbar ist.

Auf der anderen Seite ist es üblich, bei der Signalübertragung gezielt Redundanz durch Kanalcodierung wieder hinzuzufügen, um die Beeinflussung der Übertragung durch Kanalstörungen weitgehend zu beseitigen. Durch zusätzliche redundante Bits wird es somit dem Empfänger bzw. Decoder ermöglicht, Fehler zu erkennen und eventuell auch zu korrigieren. Die Bitrate der kanalcodierten Informationen wird auch Bruttobitrate genannt.

Um Informationen, insbesondere Sprachdaten, Bilddaten oder andere Nutzdaten mittels der begrenzten Übertragungskapazitäten eines Übertragungsmediums, insbesondere einer Funkschnittstelle möglichst effizient übertragen zu können, werden also diese zu übertragenden Informationen vor der Übertragung durch eine Quellencodierung komprimiert und durch eine Kanalcodierung gegen Kanalfehler geschützt. Dazu sind jeweils unterschiedliche Verfahren bekannt. So kann beispielsweise im GSM (Global System for Mobile Communication) Sprache mittels eines Full Rate Sprachcodecs eines Half Rate Sprachcodecs oder eines Enhanced Full Rate Sprachcodecs codiert werden.

Als Sprachcodec oder Codierung wird im Rahmen dieser Anmeldung auch ein Verfahren zur Encodierung und/oder zur entsprechenden Decodierung bezeichnet, das auch eine Quellen- und/oder Kanalcodierung umfassen kann und auch auf andere Daten als Sprachdaten angewendet werden kann.

Im Rahmen der Weiterentwicklung des Europäischen Mobilfunkstandards GSM wird ein neuer Standard für die codierte Sprachübertragung entwickelt, der es ermöglicht, die gesamte Datenrate, sowie die Aufteilung der Datenrate auf die Quellen- und Kanalcodierung je nach Kanalzustand und Netzbedingungen (Systemlast) adaptiv einzustellen. Dabei sollen statt der oben beschriebenen, eine feste Quellbitrate aufweisenden, Sprachcodecs neue Sprachcodecs zum Einsatz kommen, deren Quellbitrate variabel ist und welche an sich ändernde Rahmenbedingungen der Informationsübertragung angepaßt wird. Hauptziele derartiger AMR (Adaptive Multirate)-Sprachcodecs sind, Festnetzqualität der Sprache bei unterschiedlichen Kanalbedingungen zu erzielen und optimale Verteilung der Kanalkapazität unter Berücksichtigung bestimmter Netzparameter zu gewährleisten. Nach der Durchführung eines gängigen Quellencodierverfahrens liegen dabei die komprimierten Informationen strukturiert in Rahmen vor, wobei sich die Quellbitrate je nach verwendetem Codemodus von Rahmen zu Rahmen unterscheiden kann. Zur Erzielung einheitlicher Bruttobitraten werden die innerhalb eines Rahmens enthaltenen Informationen je nach Quellbitrate bzw. Codemodus unterschiedlich, insbesondere mit unterschiedlicher Rate, derart kanalcodiert, daß die nach der Kanalcodierung vorliegende Bruttobitrate dem ausgewählten Kanalmodus (Half Rate oder Full Rate) entspricht. Beispielsweise kann ein derartiger AMR-Sprachcodec unter guten Kanalbedindungen und/oder in hoch ausgelasteten Funkzellen im Half Rate(HR)-Kanal arbeiten. Es soll unter schlechten Kanalbedingungen dynamisch in den Full Rate (FR)-Kanal gewechselt werden und umgekehrt. Innerhalb eines derartigen Kanalmodus (Half Rate oder Full Rate) stehen unterschiedliche Codemodi für unterschiedliche Sprach- und Kanalcodierungsraten zur Verfügung, welche ebenfalls entsprechend der Kanalqualität gewählt werden (Ratenadaption). Dabei bleibt die Bruttobitrate nach der Kanalcodierung innerhalb eines Kanalmodus konstant (22,8 Kbit/sek. im Full Rate FR und 11,4 Kbit/sek. im Half Rate Kanal HR). Somit soll sich unter Berücksichtigung der wechselnden Kanalbedingungen die beste Sprachqualtiät ergeben. Bei einer derart adaptiven Codierung werden also abhängig von den Kanalbedindungen einer Übertragungsstrecke, von den Anforderungen bestimmter Netzparameter oder abhängig von der Sprache die Sprachcodierung gemäß verschiedener Codemodi durchgeführt, welche beispielsweise unterschiedliche Raten aufweisen (variable Quellbitrate). Da die Bruttobitrate nach der Kanalcodierung konstant bleiben soll, wird bei der Kanalcodierung eine entsprechend angepaßte variable Anzahl von Fehlerschutzbits hinzugefügt.

Zur Decodierung derart variabel codierter Informationen nach der Übertragung ist es hilfreich, wenn empfangsseitig Informationen über das sendeseitig verwendete Codierverfahren, insbesondere die Quellbitrate und/oder die sendeseitig verwendete Art der Kanalcodierung bekannt sind. Dazu ist es möglich, daß sendeseitig bestimmte Bits, sogenannte Modusbits generiert werden, welche beispielsweise die Rate angeben, mit der quellen- oder kanalcodiert wird.

Es ist bekannt, diese Modusbits unabhängig von den Quellbits (Datenbits) mit einem Blockcode zu schützen und zu übertragen. Dadurch können zunächst diese sogenannten Modusbits decodiert werden, und im Weiteren, abhängig von diesem ersten Decodierergebnis, die Quellbits ermittelt werden. Nachteilig an diesem Verfahren ist, daß die Fehlerhäufigkeit bei den Modusbits relativ hoch ist, da insbesondere bei mit Fading behafteten Mobilfunkkanälen die Korrekturfähigkeit des Decoders aufgrund der geringen Blocklänge gering ist.

Alternativ ist es möglich, die Decodierung in mehreren Schritten durchzuführen. Dazu wird zunächst entsprechend einem ersten Codemodus decodiert und mit Hilfe eines CRC (Cyclic Redundancy Check) ermittelt, ob dieser Codemodus sinnvoll war. Ist dies nicht der Fall, wird entsprechend eines weiteren Codemodus decodiert und das Ergebnis erneut geprüft. Dieses Verfahren wird mit allen Codemodi wiederholt, bis ein sinnvolles Ergebnis vorliegt. Der Nachteil dieser Methode liegt in dem hohen Rechenaufwand, der zu einem erhöhten Stromverbrauch und einer Verzögerung der Decodierung führt.

Aus US 5537410 ist es bekannt, Informationen zur Anzeige einer Rate in einem Rahmen zu übermitteln.

Der Erfindung liegt daher das Problem zugrunde, ein Verfahren und eine Anordnung zur Kanalcodierung bzw. zur Decodierung anzugeben, das es ermöglicht, Informationen über die Art der Codierung einfach und zuverlässig zu übermitteln.

Dieses Problem wird durch die Merkmale der unabhängigen Patentansprüche gelöst. Weiterbildungen der Erfindung ergeben sich aus den abhängigen Ansprüchen.

Zur Lösung der Aufgabe wird ein Verfahren angegeben, bei dem ein erster Teil erster Informationen, beispielsweise Nutzinformationen, bei unterschiedlichen Arten der Codierung unabhängig von der Art der Codierung einheitlich kanalcodiert wird.

Dadurch ist gewährleistet, daß zur Decodierung zweiter Informationen zur Beschreibung der Codierung erster Informationen auch ein erster Teil der ersten Information verwendet werden kann und somit durch die damit verbundene Vergrößerung der Blocklänge der zur Codierung der zweiten Informationen verwendeten Faltungscodes die Fehlerkorrektur der zweiten Informationen mit besserer Qualität durchgeführt werden kann. Eine mehrfache Decodierung nach dem oben beschriebenen Try and Error-Prinzip kann vermieden werden.

Informationen zur Beschreibung der Codierung erster Informationen können dabei Informationen zur Beschreibung der Quellencodierung und/oder der Kanalcodierung und/oder andere zur Decodierung erster Informationen, wie beispielsweise die Art der Codierung (Quellen- und/oder Kanalcodierung der ersten Informationen) oder die Rate der Codierung (Quellen- und/oder Kanalcodierung der ersten Informationen) enthalten.

Insbesondere wenn die Codierung der Informationen adaptiv auf unterschiedliche Arten erfolgen kann, kann die Erfindung vorteilhaft Einsatz finden.

Bei einer Ausgestaltung der Erfindung wird die Rate der Kanalcodierung zumindest eines zweiten Teils der ersten Informationen, beispielsweise der Nutzinformation an die Qualität des Übertragungskanals und/oder die Netzlast angepaßt. So ist es möglich, die Kanalcodierung an sich ändernde Rahmenbedingungen eines Kommunikationssystems anzupassen, und diese sendeseitige Anpassung auf einfache und zuverlässige Weise an einen Empfänger zu übermitteln.

Bei weiteren Ausgestaltungen enthalten die zweiten Informationen Signalisierungsinformationen und/oder Informationen zur Beschreibung der Empfangsqualität, um abhängig vom aktuellen Empfangsergebnis einen Sender zu beeinflussen. So ist es möglich, die Übertragung von Informationen nach dem Prinzip einer Regelschleife zu steuern.

Zur Kanalcodierung ist es vorteilhaft Faltungscodes zu verwenden, und die Länge des ersten Teils der ersten Informationen, der einheitlich kanalcodiert wird, zumindest ungefähr an die Einflußlänge des verwendenden Faltungscodes anzupassen.

Ferner wird das Problem gelöst durch ein Verfahren zur Decodierung von in Rahmen strukturierten Informationen, bei dem zur Decodierung zweiter Informationen auch ein erster Teil der ersten Information verwendet wird. Dies ermöglicht die codierte Übertragung zweiter Informationen mit einer hinreichend großen Blocklänge und vermeidet ein aufwendiges Mehrfachdecodieren nach dem oben beschriebenen Try and Error-Prinzip.

Insbesondere wenn im Rahmen einer Informationsübertragung die Informationen sendeseitig nach einem der oben beschriebenen Verfahren codiert wurden, ist eine derart durchgeführte Decodierung vorteilhaft.

Das Problem wird außerdem gelöst durch Anordnungen zur Kanalcodierung bzw. Decodierung von in Rahmen strukturierten Informationen bei denen jeweils ein digitaler Signalprozessor derart eingerichtet ist, daß ein erster Teil der ersten Information bei unterschiedlichen Arten der Codierung unabhängig von der Art der Codierung einheitlich kanalcodierbar ist, bzw. daß zur Decodierung zweiter Informationen auch ein erster Teil der ersten Informationen verwendbar ist. Diese Anordnungen sind insbesondere geeignet zur Durchführung der erfindungsgemäßen Verfahren oder einer ihrer vorstehend erläuterten Weiterbildung.

Ausführungsbeispiele werden nachfolgend anhand der folgenden Zeichnungen dargestellt und erläutert. Dabei wird besonders die digitale Übertragung der Informationen beschrieben. Dennoch ist die Erfindung auch zur Speicherung von Informationen anwendbar, da das Schreiben von Informationen auf ein Speichermedium und das Lesen von Informationen von einem Speichermedium hinsichtlich der vorliegenden Erfindung dem Senden von Informationen und dem Empfangen von Informationen entspricht.
- Figur 1: Prinzipschaltbild eines Mobilfunksystems;
- Figur 2: schematische Darstellung wesentlicher Elemente einer nachrichtentechnischen Übertragungskette;
- Figur 3: schematische Darstellung eines adaptiven Codierschemas;
- Figur 4: schematische Darstellung eines adaptiven Codierschemas im Vollratenkanal;
- Figur 5: schematische Darstellung eines adaptiven Codierschemas im Halbratenkanal;
- Figur 6: Prinzipschaltbild einer Prozessoreinheit.

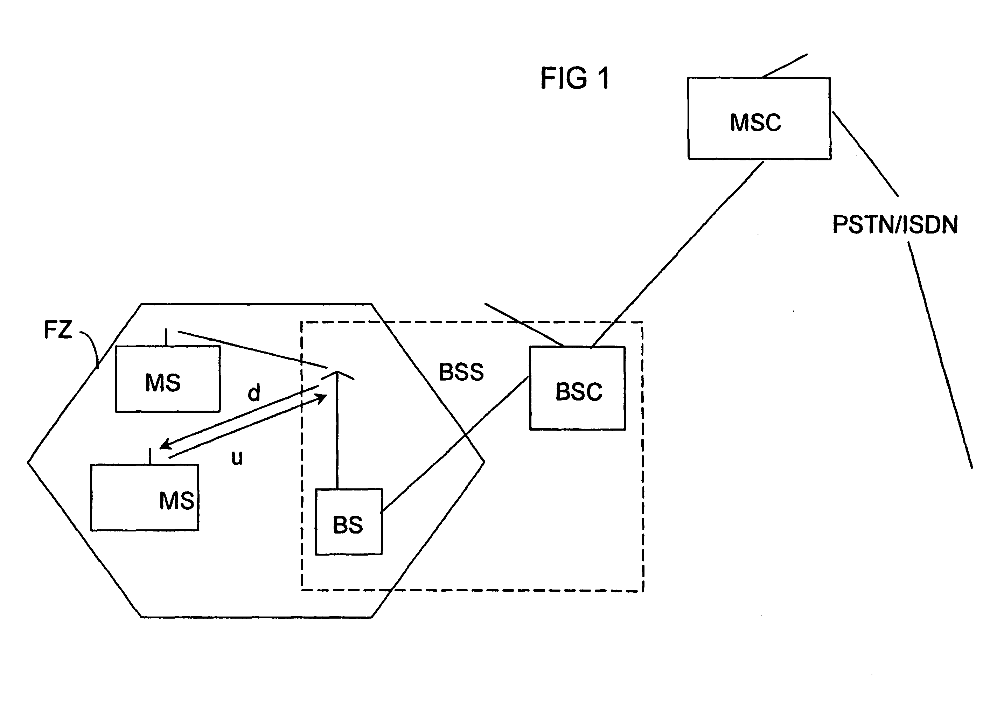

Das in Figur 1 dargestellte Mobilfunksystem entspricht in seiner Struktur einem bekannten GSM-Mobilfunksystem, das aus einer Vielzahl von Mobilvermittlungsstellen MSC besteht, die untereinander vernetzt sind bzw. den Zugang zu einem Festnetz PSTN herstellen. Ferner sind diese Mobilvermittlungsstellen MSC mit jeweils zumindest einem Basisstationscontroller BSC verbunden, der auch durch ein Datenverarbeitungssystem gebildet sein kann. Jeder Basisstationscontroller BSC ist wiederum mit zumindest einer Basisstation BS verbunden. Eine solche Basisstation BS ist ein Funkgerät, das über eine Funkschnittstelle eine Funkverbindung zu Funkgeräten, sogenannten Mobilstationen MS aufbauen kann.

Die Reichweite der Signale einer Basisstation definiert im wesentlichen eine Funkzelle FZ. Die Zuteilung von Ressourcen wie Frequenzbänder zu Funkzellen und damit zu den zu übertragenden Datenpaketen kann durch Steuereinrichtungen wie beispielsweise die Basisstationscontroller BSC gesteuert werden. Basisstationen BS und ein Basisstationscontroller BSC können zu einem Basisstationssystem BSS zusammengefaßt werden.

Das Basisstationssystem BSS ist dabei auch für die Funkkanalverwaltung, die Datenratenanpaßung, die Überwachung der Funkübertragungsstrecke, Händ-Over-Prozeduren, die Verbindungssteuerung und gegebenenfalls für die Zuteilung bzw. Signalisierung der zu verwendenden Sprachcodecs zuständig und übermittelt gegebenenfalls entsprechende Signalisierungsinformationen zu den Mobilstationen MS. Die Übermittlung derartiger Signalisierungsinformationen kann auch über Signalisierungskanäle erfolgen.

Anhand der vorliegenden Beschreibung kann die Erfindung auch zur Signalisierung anderer Informationen, wie beispielsweise Art der Information (Daten, Sprachen, Bilder, etc.) und/oder deren Codierung, Umschaltinformationen in beliebigen Übertragungsverfahren, wie beispielsweise DECT, WB-CDMA oder Multimodeübertragungsverfahren (GSM/WB-CDMA/TD-CDMA) innerhalb eines UMTS (Universal Mobile Telephony System) verwendet werden.

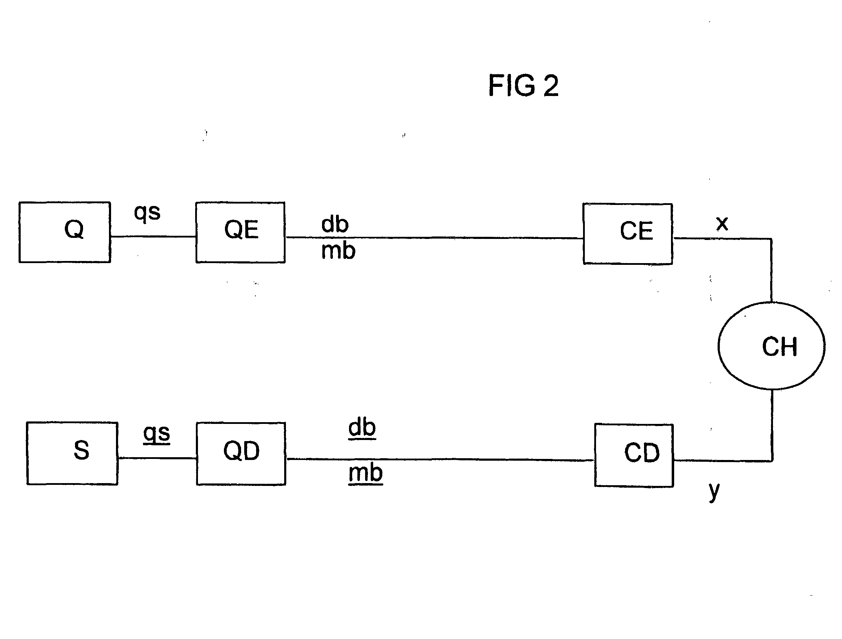

Figur 2 zeigt eine Quelle Q, die Quellensignale qs erzeugt, die von einem Quellencodierer QE, wie dem GSM Full Rate Sprachcodierer, zu aus Symbolen bestehenden Symbolfolgen komprimiert werden. Bei parametrischen Quellencodierverfahren werden die von der Quelle Q erzeugten Quellensignale qs (z.B. Sprache) in Blöcke unterteilt (z.B. zeitliche Rahmen) und diese getrennt verarbeitet. Der Quellencodierer QE erzeugt quantisierte Parameter (z.B. Sprachkoeffizienten), die im folgenden auch als Symbole einer Symbolfolge bezeichnet werden, und die die Eigenschaften der Quelle im aktuellen Block auf eine gewisse Weise widerspiegeln (z.B. Spektrum der Sprache, Filterparameter). Diese Symbole weisen nach der Quantisierung einen bestimmten Symbolwert auf.

Die Symbole der Symbolfolge bzw. die entsprechenden Symbolwerte werden durch eine binäre Abbildung (Zuordnungsvorschrift), die häufig als Teil der Quellencodierung QE beschrieben wird, auf eine Folge binärer Codewörter abgebildet, die jeweils mehrere Bitstellen aufweisen. Werden diese binären Codewörter beispielsweise nacheinander als Folge binärer Codewörter weiterverarbeitet, so entsteht eine Folge von quellencodierten Bitstellen, die in einer Rahmenstruktur eingebettet sein können.

Mit Hilfe von hier nicht erläuterten Verfahren wird beispielsweise die ursprüngliche Rate eines Telefonsprachsignals (64 kbit/s µlaw, 104 kbit/s lineare PCM) deutlich reduziert (ca. 5 kbit/s - 13 kbit/s, abhängig vom Codierverfahren). Fehler in diesem Bitstrom wirken sich unterschiedlich auf die Sprachqualität nach der Decodierung aus. Fehler in manchen Bits führen zu Unverständlichkeit oder lauten Geräuschen, Fehler in anderen Bits dagegen sind kaum wahrnehmbar. Dies führt zu einer Einteilung der Bits nach dem Quellencodierer QE in Klassen, die meist auch unterschiedlich gegen Fehler geschützt werden (Bsp.: GSM-Full Rate: Klasse la, 1b und 2). Nach einer derart durchgeführten Quellencodierung liegen Quellbits oder Datenbits db mit einer von der Art der Quellencodierung abhängigen Quellbitrate strukturiert in Rahmen vor.

In Mobilfunksystemen haben sich zur anschließenden Kanalcodierung Faltungscodes als effiziente Codes erwiesen. Diese besitzen bei großer Blocklänge eine große Fehlerkorrekturfähigkeit und eine angemessene Decodierkomplexität. Im folgenden werden beispielhaft nur Faltungscodes der Rate 1/*n* behandelt. Ein Faltungscoder mit Gedächtnis m erzeugt über ein Register aus den letzten *m*+1 Datenbits n Codebits.

Wie bereits oben erläutert, werden Bits bei der Sprachcodierung in Klassen eingeteilt und unterschiedlich gegen Fehler geschützt. Dies geschieht bei der Faltungscodierung durch unterschiedliche Raten. Raten größer als ½ werden durch Punktierung erzielt.

Bei der Standardisierungsgruppe für Mobilfunksysteme in Europa (ETSI) wird zur Zeit eine neue Sprach- und Kanalcodierung für das bestehende GSM standardisiert. Dabei soll die Sprache gemäß verschiedener Codemodi mit unterschiedlichen Raten quellencodiert werden und die Kanalcodierung entsprechend angepaßt werden, so daß in einem Kanalcodierer CE, wie einem Faltungscodierer, eine Codierung der quellencodierten Bitfolgen gegen Kanalstörungen derart erfolgt, daß die Bruttobitrate weiterhin 22,8 kbit/s (Vollratenmodus) bzw. 11,4 kbit/s (Halbratenmodus) beträgt. Die aktuelle Quellbitrate wird dabei abhängig von der Sprache (Pause, Zischlaute, Selbstlaute, stimmhaft, stimmlos usw.), abhängig von den Kanalbedingungen (guter, schlechter Kanal) oder abhängig von Netzbedingungen (Überlastung, Kompatibilität usw.) geändert. Die Kanalcodierung wird entsprechend angepaßt. Die aktuell verwendete Rate (beispielsweise durch den aktuellen Codemodus) und/oder weitere Informationen werden innerhalb desselben Rahmens als Modusbits mb übermittelt.

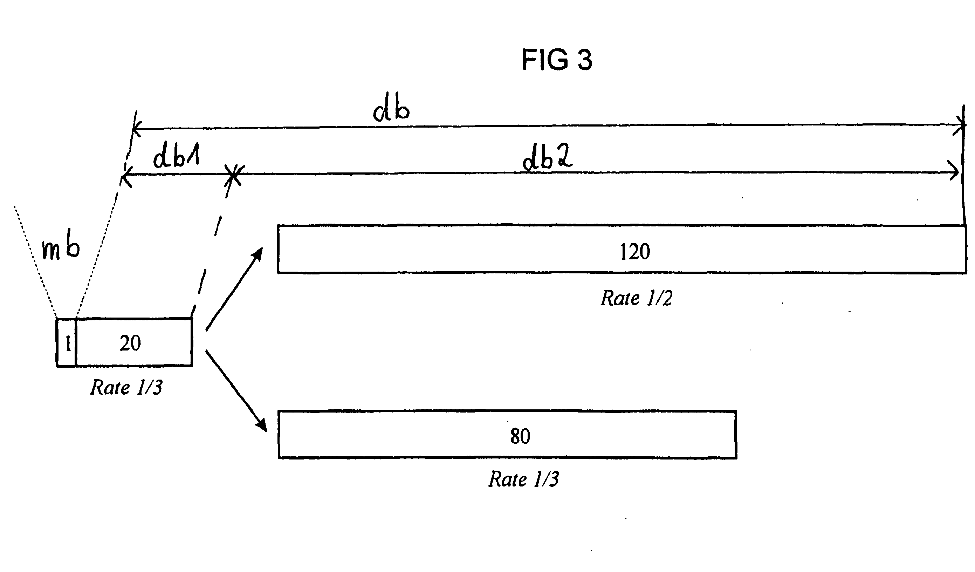

Wie in Figur 3 dargestellt werden im Sinne einer hierarchischen Codierung, für alle verwendeten Quellbitraten bzw. Sprachcodierraten bzw. Codemodi der erste Teil der Datenbits db1 gleich codiert. Bei diesem ersten Teil db1 kann es sich um die ca. 5·*m* ersten Quellenbits handeln. Im Kanaldecoder QD wird dann das Trellis für diesen ersten Teil aufgebaut, und es werden zunächst die Modusbits entschieden bzw. decodiert. Aus diesen Modusbits mb wird die aktuelle Sprachrate bzw. der aktuelle Codemodus ermittelt und entsprechend dem für diese Rate bzw. diesen Codemodus benutzten Decodierverfahren auch der zweite Teil der Datenbits db2 decodiert.

Der erste Teil oder ein anderer Teil der Datenbits db1 kann auch zusammen mit den Modusbits mb unabhängig von der Art der Quellencodierung einheitlich kanalcodiert werden, d.h. unabhängig von dem aktuellen Codemodus werden ein erster Teil der Datenbits db1 zusammen mit den Modusbits mb kanalcodiert, und zwar ebenfalls für alle Codemodi gemäß einem einheitlichen Verfahren.

Dies sei anhand Figur 3 an einem einfachen Beispiel erläutert:
Ein Quellencodierverfahren erzeugt gemäß zweier verschiedener Codemodi Rahmen oder Blöcke mit einer Länge von 140 Datenbits db (Fall 1) bzw. 100 Datenbits db (Fall 2). Durch ein zusätzlich im selben Rahmen zu übertragendes Modusbit mb soll angezeigt werden, welche der beiden Blocklängen vom Quellencoder QE gerade generiert wurde. Nach der Kanalcodierung soll in beiden Fällen ein Rahmen der Länge 303 Bits erzeugt werden, was zwangsläufig für die beiden Fälle zu unterschiedlichen Kanalcodierverfahren zumindest hinsichtlich der Rate führt. Es wird nun vorgeschlagen in beiden Fällen einen ersten Teil der Datenbits db1, beispielsweise die ersten 20 Bits einheitlich, beispielsweise hinsichtlich der Rate (Rate 1/3) der angewendeten Faltungscodes, der angewendeten Generatorpolynome oder des angewendeten Gedächnisses, kanalzucodieren, und die Anpassung an die einheitliche Rahmenlänge von 303 Bits durch die Anwendung unterschiedlicher Raten (Rate ½ für Fall 1; Rate 1/3 für Fall 2) in der Kanalcodierung auf den zweiten Teil der 120 (Fall 1) bzw. 80 (Fall 2) Datenbits db2 durchzuführen.

Bei einer Ausführungsvariante der Erfindung wird bzw. werden das Modusbit bzw. die Modusbits mb zusammen mit dem ersten Teil der Datenbits db1 in beiden Fällen einheitlich, beispielsweise hinsichtlich der Rate (Rate 1/3) der angewendeten Faltungscodes, der angewendeten Generatorpolynome oder des angewendeten Gedächnisses, kanalcodiert, insbesondere faltungscodiert.

Bei der Decodierung kann das Trellis eines Faltungsdecoders für die ersten 21 Bits (ein Modusbit mb + 20 erste Datenbits db1) eines Faltungsdecoders aufgebaut werden, ohne daß bekannt ist welche Datenblocklänge bei der Codierung verwendet wurde. Ist das Trellis über diese Länge aufgebaut, kann das erste Bit (das Modusbit mb) ermittelt werden. Dabei ist die Einflußlänge des Codes berücksichtigt und somit ist die Fehlerrate deutlich geringer als bei einem Aufbau des Trellis nur für dieses erste Modusbit. Nachdem dieses Modusbit bestimmt wurde, ist auch die verwendete Blocklänge bzw. der verwendete Codemodus bekannt und abhängig davon wird der zweite Teil der Datenbits db2 mit Rate 1/2 bzw. Rate 1/3 decodiert.

Die Komplexität der Decodierung ist somit nur unwesentlich höher als die Decodierung gemäß nur einem Codemodus. Um bei schlechten Kanälen die Fehlerrate unter der Kanalfehlerrate zu halten, kann ein systematischer Faltungscode verwendet werden. Um dennoch sehr gute Korrektureigenschaften bei guten Kanälen zu erzielen, kann ein rekursiver Code eingesetzt werden. Die Fehlerrate ist für gute Kanäle dann höher als bei nichtsystematischen nichtrekursiven Faltungscode (bisheriges GSM). Dies wirkt sich jedoch erst bei einer Fehlerrate von 10⁻⁴ und niedriger aus. In diesem Bereich können auftretende Fehler erkannt und verschleiert werden; die Sprachqualität wird nicht beeinträchtigt.

Im folgenden wird sowohl ein Schema für den Halbraten- als auch für den Vollratenkanal vorgestellt.

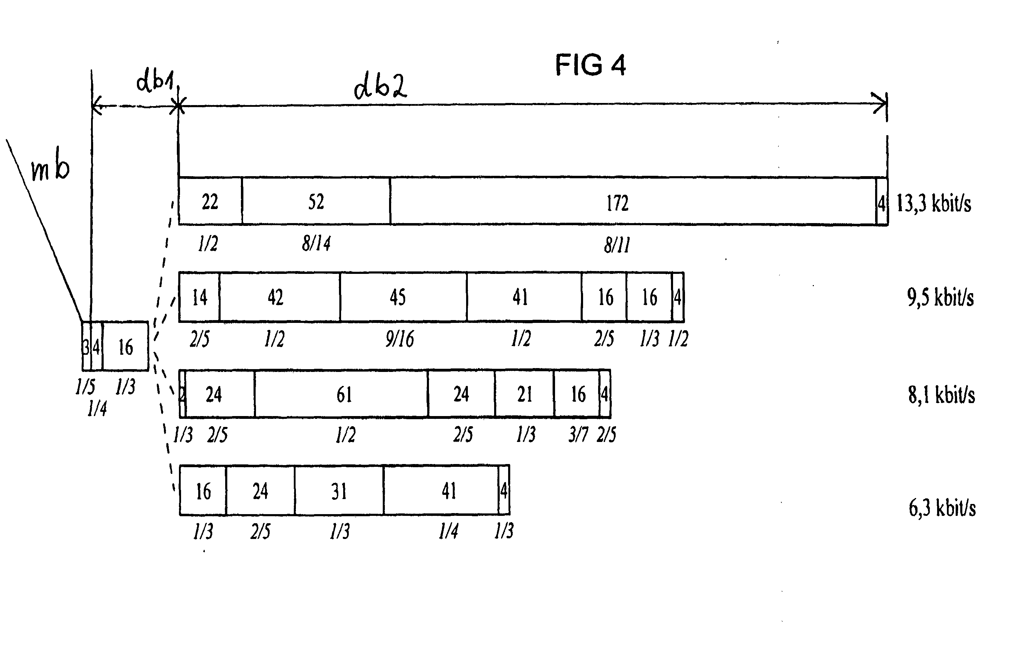

Figur 4 zeigt das Schema für den Vollratenkanal (FR) : Durch die Sprachcodierung werden mit 13,3 kbit/s (Codemodus 1), 9,5 kbit/s (Codemodus 2), 8,1 kbit/s (Codemodus 3) und 6,3 kbit/s (Codemodus 4) vier verschiedene Raten generiert. Die Codierung erfolgt in Rahmen oder Blöcken mit der Dauer 20 ms. Zusätzlich wird vor der Faltungscodierung beim Codemodus 2 ein CRC mit 4 Bits hinzugefügt und bei den Codemodi 3 und 4 je 2 CRCs mit je 3 Bit. Dies führt zu Blocklängen von 266 Bits db (Codemodus 1), 199 Bits db (Codemodus 2), 168 Bits db (Codemodus 3) und 132 Bits db (Codemodus 4). Um den aktuellen Codemodus mitzuteilen und um weitere Signalisierungsinformationen zu übertragen werden 3 Modusbits mb an den Anfang jeden Blocks oder Rahmens gestellt. Für die Codierung wird ein rekursiv systematischer Faltungscode der Raten 1/2 und 1/3 verwendet. Raten 1/4 und 1/5 werden durch Wiederholung von Bits erzeugt, höhere Raten durch Punktierung. Wieder werden für alle vier Codemodi die Modusbits mb und ein erster Teil der Datenbits db1 gleichermaßen kanalcodiert, wobei die Modusbits mb immer mit einer Rate 1/5 kanalcodiert werden und der erte Teil der Datenbits db1 immer mit einer Rate 1/3 bzw. 1/4 kanalcodiert werden.

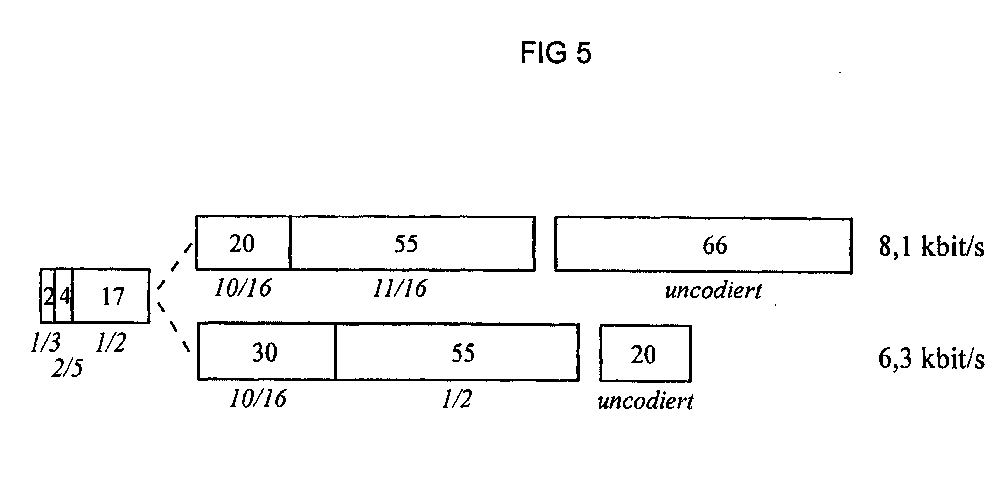

Figur 5 zeigt das Schema für den Halbratenkanal (HR): Das bereits erläuterte Prinzip der gleichen Codierung der Modusbits und der ersten Datenbits wird auch für den Halbratenkanal realisiert. Dort werden nur die Codemodi 3 (8,1 kbit/s) und 4 (6,3 kbit/s) benutzt und durch Kanalcodierung auf 11,4 kbit/s ergänzt. Da weniger Codemodi benutzt werden, genügen im Halbratenkanal zwei Modusbits. Es wird der gleiche Faltungscoder wie im Vollratencodec verwendet, dieser wird jedoch nicht terminiert.

Wie in Figur 2 dargestellt werden die an die Quellencodierung angepaßt kanalcodierten Bitfolgen x oder Codebits in einem nicht dargestellten Modulator weiterverarbeitet und anschließend über eine Übertragungsstrecke CH übertragen. Bei der Übertragung treten Störungen auf, wie beispielsweise Fading, oder Rauschen auf.

Die Übertragungsstrecke CH liegt zwischen einem Sender und einem Empfänger. Der Empfänger enthält gegebenenfalls eine nicht dargestellte Antenne zum Empfang der über die Übertragungsstrecke CH übertragenen Signale, eine Abtasteinrichtung, einen Demodulator zum Demodulieren der Signale und einen Entzerrer zum Eliminieren der Intersymbolstörungen. Diese Einrichtungen wurden ebenfalls aus Vereinfachungsgründen in Figur 1 nicht dargestellt. Auch ein mögliches Interleaving und Deinterleaving ist nicht dargestellt.

Der Entzerrer gibt Empfangswerte einer Empfangsfolge y aus. Die Empfangswerte haben aufgrund der Störungen bei der Übertragung über die Übertragungsstrecke CH Werte, die von "+1" und "-1" abweichen.

In einem Kanaldecodierer CD wird die Kanalcodierung rückgängig gemacht. Vorteilhaft wird zur Decodierung von Faltungscodes der Viterbi-Algorithmus verwendet. Abhängig vom Gedächtnis m des Faltungscodes beträgt die Einflußlänge bei der Decodierung ca. 5·*m*. Damit soll ausgedrückt werden, daß im allgemeinen bis zu dieser Einflußlänge Fehler im Code noch korrigiert werden können. Durch weiter entfernte Codebits im zu decodierenden Block findet keine Korrektur des aktuellen Informationsbits statt.

Um eine möglichst geringe Fehlerrate des ersten Bits eines Decoders zu erzielen, wird das Trellis des Decoders bis zum ca. 5·*m* entfernten Datenbit aufgebaut. Anschließend wird eine Entscheidung über das erste Bit getroffen. Bei einem System mit unterschiedlichen Quellencodierraten ist im allgemeinen auch die Quellencodierung der ersten 5·*m* Bits unterschiedlich. Dies bedeutet, daß auch die Quellendecodierung für diese Bits unterschiedlich ist und somit abhängig von der verwendeten Quellencodierrate bzw. vom verwendeten Codemodus unterschiedlich decodiert werden muß.

Nach erfolgter Kanaldecodierung CD liegen die empfangenen Modusbits mb und Datenbits db vor und es erfolgt eine Quellendecodierung QD in empfangene Quellensignale qs, die an der Informationssinke S ausgegeben werden.

Bei Ausgestaltungsvarianten der Erfindung können mittels der Modusbits auch andere Informationen, insbesondere Steuer- oder Signalisierungsinformationen übertragen werden, wie beispielsweise Kanalzustandsinformationen oder Antworten auf die Signalisierungsinformationen (Rückkanal), Informationen zur Beschreibung der angewandten Codierung oder der anzuwendenden Decodierung oder andere Informationen, die zur Decodierung der ersten Informationen verwendet werden können.

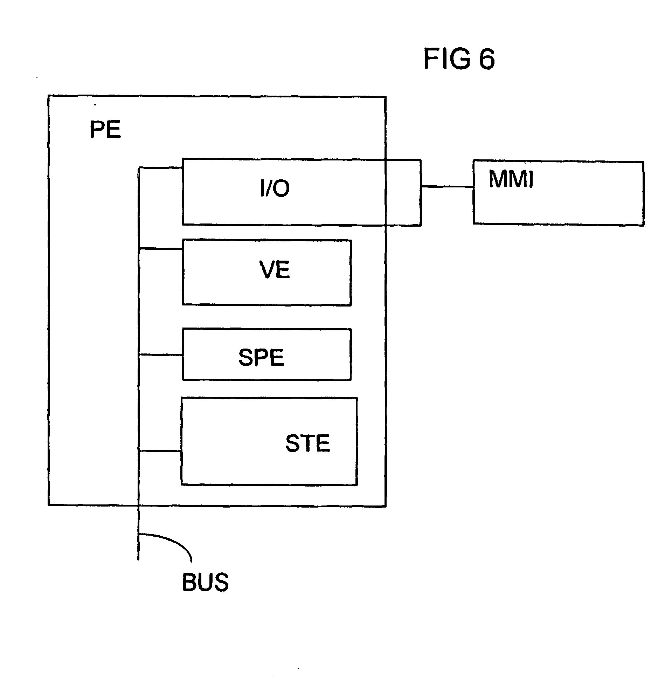

Figur 6 zeigt eine Prozessoreinheit PE, die insbesondere in einer Kommunikationseinrichtung, wie einer Basisstation BS oder Mobilstation MS enthalten sein kann. Sie enthält eine Steuereinrichtung STE, die im wesentlichen aus einem programmgesteuerten Microcontroller besteht, und eine Verarbeitungseinrichtung VE, die aus einem Prozessor, insbesondere einem digitalen Signalprozessor besteht, die beide schreibend und lesend auf Speicherbausteine SPE zugreifen können.

Der Microcontroller steuert und kontrolliert alle wesentlichen Elemente und Funktionen einer Funktionseinheit, die die Prozessoreinheit PE enthält. Der digitale Signalprozessor, ein Teil des digitalen Signalprozessors oder ein spezieller Prozessor ist für die Durchführung der Codierung bzw. Decodierung zuständig. Die Auswahl der Sprachcodecs kann auch durch den Microcontroller oder den digitalen Signalprozessor selbst erfolgen.

Eine Input/Output-Schnittstelle I/O, dient der Ein/Ausgabe von Nutz- oder Steuerdaten beispielsweise an eine Bedieneinheit MMI, die eine Tastatur und/oder ein Display enthalten kann.

## Patentansprüche

1. Verfahren zur Kanalcodierung von in Rahmen strukturierten Daten,
- bei dem innerhalb eines Rahmens Datenbits (db) enthalten sind, die gemäß einem Codemodus quellencodiert sind, wobei der Codemodus aus einer Vielzahl möglicher Codemodi ausgewählt ist,
- bei dem innerhalb des Rahmens zumindest ein Modusbit (mb) zur Kennzeichnung des aktuellen Codemodus der Datenbits enthalten ist, und
- bei dem ein erster Teil der Datenbits (db1) und zumindest das Modusbit (mb) unabhängig vom aktuellen Codemodus einheitlich kanalcodiert werden.

2. Verfahren nach Anspruch 1, bei dem
die Auswahl des aktuellen Codemodus an die Qualität des Übertragungskanals und/oder die Netzlast angepaßt wird.

3. Verfahren nach einem der vorhergehenden Ansprüche, bei dem die Modusbits (mb) Signalisierungsinformationen und/oder Informationen zur Beschreibung der Empfangsqualität enthalten.

4. Verfahren nach einem der vorhergehenden Ansprüche, bei dem zur Kanalcodierung Faltungscodes verwendet werden, und der erste Teil der Datenbits, der einheitlich kanalcodiert wird, in Abhängigkeit von der Einflußlänge des Faltungscodes gewählt wird.

5. Verfahren zur Decodierung von in Rahmen strukturierten Daten, die gemäß einem Verfahren nach einem der Ansprüche 1 bis 4 codiert wurden,
- bei dem zur Kanaldecodierung zumindest eines Modusbits (mb) auch ein erster Teil der kanalcodierten Datenbits (db1) verwendet wird.

6. Verfahren nach Anspruch 5, bei dem
das oder jedes Modusbit (mb) nur einmal kanaldecodiert wird.

7. Anordnung zur Kanalcodierung von in Rahmen strukturierten Daten, wobei innerhalb eines Rahmens Datenbits (db) enthalten sind, die gemäß einem Codemodus quellencodiert sind, wobei der Codemodus aus einer Vielzahl möglicher Codemodi ausgewählt ist, und wobei innerhalb des Rahmens zumindest ein Modusbit (mb) zur Kennzeichnung des aktuellen Codemodus der Datenbits enthalten ist,
- mit einer Prozessoreinheit, die derart eingerichtet ist, daß ein erster Teil der Datenbits (db1) und zumindest ein Modusbit (mb) unabhängig vom aktuellen Codemodus einheitlich kanalcodiert werden.

8. Anordnung zur Decodierung von in Rahmen strukturierten Daten, die gemäß einem Verfahren nach einem der Ansprüche 1 bis 4 codiert wurden,
- mit einer Prozessoreinheit, die derart eingerichtet ist, daß zur Kanaldecodierung zumindest eines Modusbits (mb) auch ein erster Teil der kanalcodierten Datenbits (db1) verwendet wird.

## Claims

1. Method for channel coding of data structured in frames,
- in which a frame contains data bits (db) which are source-coded in accordance with a code mode, with the code mode being selected from a large number of possible code modes,
- in which the frame contains at least one mode bit (mb) for identifying the particular code mode of the data bits, and
- in which a first portion of the data bits (db1) and at least the mode bit (mb) are channel-coded in a standard manner independently of the particular code mode.

2. Method according to Claim 1, in which
the selection of the particular code mode is matched to the quality of the transmission channel and/or to the network load.

3. Method according to one of the preceding claims, in which the mode bits (mb) contain signalling information and/or information for describing the reception quality.

4. Method according to one of the preceding claims, in which convolution codes are used for channel coding, and the first portion of the data bits, which is channel-coded in a standard manner, is selected as a function of the length of influence of the convolution code.

5. Method for decoding data which is structured in frames and has been coded using a method according to one of Claims 1 to 4,
- in which a first portion of the channel-coded data bits (db1) is also used for channel decoding of at least one mode bit (mb).

6. Method according to Claim 5, in which the or each mode bit (mb) are channel-decoded only once.

7. Arrangement for channel coding of data structured in frames, with a frame containing data bits (db) which are source-coded in accordance with a code mode, with the code mode being selected from a large number of possible code modes, and with the frame containing at least one mode bit (mb) for identifying the particular code mode of the data bits,
- having a processor unit which is set up in such a manner that a first portion of the data bits (db1) and at least one mode bit (mb) are channel-coded in a standard manner, independently of the particular code mode.

8. Arrangement for decoding data which are structured in frames and have been coded in accordance with a method according to one of Claims 1 to 4,
- having a processor unit which is set up in such a manner that a first portion of the channel-coded data bits (db1) is also used for channel decoding at least one mode bit (mb).

## Revendications

1. Procédé pour le codage canal de données à structure de trame,
- dans lequel des bits de données (db), codés source selon un mode de code, sont contenus dans une trame, le mode de code étant sélectionné à partir d'une pluralité de modes de code possibles,
- dans lequel au moins un bit de mode (mb) est contenu dans la trame pour marquer le mode de code actuel des bits de données, et
- dans lequel une première partie des bits de données (db1) et au moins le bit de mode (mb) sont codés canal de manière homogène indépendamment du mode de code actuel.

2. Procédé selon la revendication 1, dans lequel
la sélection du mode de code actuel est adaptée à la qualité du canal de transmission et/ou à la charge du réseau.

3. Procédé selon l'une quelconque des revendications précédentes, dans lequel
les bits de mode (mb) contiennent des informations de signalisation et/ou des informations de description de la qualité de réception.

4. Procédé selon l'une quelconque des revendications précédentes, dans lequel des codes de convolution sont utilisés pour le codage canal, et la première partie des bits de données, qui est codée canal de manière homogène, est sélectionnée en fonction de la longueur d'influence du code de convolution.

5. Procédé pour le décodage de données à structure de trame, qui ont été codées selon un procédé selon l'une des revendications 1 à 4,
- dans lequel une première partie des bits de données (db1) codés canal est également utilisée pour le décodage canal au moins d'un bit de mode (mb).

6. Procédé selon la revendication 5, dans lequel
le ou chaque bit de mode (mb) n'est codé canal qu'une seule fois.

7. Dispositif pour le codage canal de données à structure de trame, des bits de données (db), codés canal selon un mode de code, étant contenus dans une trame, le mode de code étant sélectionné à partir d'une pluralité de modes de code possibles, au moins un bit de mode (mb) étant contenu dans la trame pour marquer le mode de code actuel des bits de données,
- comprenant une unité de processeur qui est disposée de telle manière qu'une première partie des bits de données (db1) et au moins un bit de mode (mb) sont codés canal de manière homogène indépendamment du mode de code actuel.

8. Dispositif pour le décodage de données à structure de trame, qui ont été codées selon un procédé selon l'une des revendications 1 à 4,
- comprenant une unité de processeur qui est disposée de telle manière qu'une première partie des bits de données (db1) codés canal est également utilisée pour le décodage canal au moins d'un bit de mode (mb).
